# EUROPÄISCHE PATENTSCHRIFT

(11) **EP 1 054 844 B1**
(45) Veröffentlichungstag und Bekanntmachung des Hinweises auf die Patenterteilung: **02.01.2002**
(21) Anmeldenummer: 98955314.4
(22) Anmeldetag: 14.09.1998
(51) Int. Cl.: C04B 2/00

(54) **VERBUNDWERKSTOFF**
COMPOSITE
MATERIAU COMPOSITE

(30) Priorität: 20.09.1997 DE 19741580
(43) Veröffentlichungstag der Anmeldung: 29.11.2000
(73) Patentinhaber: ROBERT BOSCH GMBH, 70442 Stuttgart (DE)
(72) Erfinder: GRÜNWALD, Werner, D-70839 Gerlingen (DE); ALKEMADE, Ulrich, D-71229 Leonberg (DE); FRIESE, Karl-Hermann, D-71229 Leonberg (DE); MARTIN, Chuck, Fort Collins, CO 80521 (US)
(86) Internationale Anmeldenummer: DE9802707
(87) Internationale Veröffentlichungsnummer: WO9915474

(56) Entgegenhaltungen:
- EP-A- 0 685 540
- WO-A-97/05302
- US-A- 4 483 751
- US-A- 4 563 397
- US-A- 5 470 636

## Beschreibung

### Stand der Technik

Die Erfindung geht aus von einem Verbundwerkstoff sowie einem Verfahren zu dessen Herstellung nach der Gattung der unabhängigen Ansprüche.

Verbund- oder Funktionswerkstoffe, die Materialien unterschiedlicher Wärmeausdehnungskoeffizienten (WAK) vereinen, finden große Anwendung, insbesondere in der Leiterplatten-, aber auch in der Keramiktechnik. Die unterschiedlichen Wärmeausdehnungskoeffizienten verschiedener Materialien, die zusammen einen Verbundwerkstoff ergeben, führen zu Problemen hinsichtlich thermischer Spannungen mit eventueller Rissbildung des so hergestellten Materials. Beispielsweise ist es bei der Herstellung von Mehrlagenkeramiken möglich, dieses Problem zu umgehen, indem durch verschiedene aufeinanderfolgende Lagen unterschiedlicher Materialien mit geringen Anderungen des Wärmeausdehnungskoeffizienten ermöglicht wird, dass beispielsweise die obere und die untere Lage eine große Differenz des Wärmeausdehnungskoeffizienten aufweisen. Jedoch haben sich alle diese Lösungen als unbefriedigend erwiesen, da es bislang nicht möglich war, zwei Materialien mit einer großen Differenz in ihrem Wärmeausdehnungskoeffizienten direkt miteinander zu kombinieren. Es ist nur eine Lösung der Firma DuPont bekannt, bei der durch Einstanzen von kleinen Stanzteilen verschiedener Form in Folien des einen Materials aus einer darüberliegenden Folie eines zweiten Materials mit unterschiedlichem WAK, eine direkte Kombination dieser zwei Materialien mit unterschiedlichem WAK ermöglicht wird. Dies findet insbesondere Verwendung bei der Herstellung von Glaskeramikfolien, die für keramische Hochtemperaturfolien entwickelt werden, die vor allem bei Dickschichthybridschattierungen (Mehrlagen) Anwendung in der Mikroelektrotechnik finden. Aufgrund der kleinen geometrischen Abmessung des eingestanzten Materialkörpers sind die Absolutwerte der auftretenden Spannungen trotz unterschiedlichen Wärmeausdehnungskoeffizienten derart klein, dass es auch bei Temperaturwechsel zu keiner Rissbildung im Gesamtsystem kommt.

Aus US 5,470,636 ist ein magnetisches Aufzeichnungsmedium bekannt, bei dem auf einem Aluminiumsubstrat durch anodische Oxidation ein Aluminiumoxidfilm erzeugt worden ist. Weiter ist dort eine weitere, Poren in dem Aluminiumoxidfilm ausfüllende Beschichtung vorgesehen. In US 4,563,397 ist ein ähnliches magnetisches Aufzeichnungsmedium beschrieben, das elektrolytisch in Gegenwart von Eisen/Kobalt-Salzlösungen beschichtet wurde, wobei die im Nanometerbereich weiten Poren der Oxidschicht mit Metall gefüllt worden sind. Aus US 4,483,751 sind schließlich anodisch oxidierte und an ihrer Oberfläche Mikroporen aufweisende Substrate bekannt, die mit metallorganischen Verbindungen imprägniert wurden, die unter anderem die Mikroporen ausfüllen.

### Vorteile der Erfindung

Der erfindungemäße plattenförmige Verbundwerkstoff, der mindestens zwei Komponenten mit unterschiedlichen Wärmeausdehnungskoeffizienten enthält, besitzt vorteilhafterweise ein erstes Material, welches eine Vielzahl kleiner Öffnungen mit einem Durchmesser kleiner 300 nm aufweist, in welchen sich zumindest bereichsweise das zweite Material befindet. Dadurch ist es vorteilhafterweise möglich, zwei Materialien unterschiedlicher Wärmeausdehnungskoeffizienten, die auch größere Differenzen, beispielsweise bis zu 8 ppm/K aufweisen können, zu kombinieren, da aufgrund der kleinen geometrischen Abmessungen dieser Öffnungen, die mit dem zweiten Material gefüllt sind, die Absolutwerte der auftretenden Spannungen derart klein sind, so dass es auch bei rapiden Temperaturwechseln zu keiner Rissbildung des Gesamtsystemes kommt.

Durch die kleinen geometrischen Abmessungen der Öffnungen erlauben es diese vorteilhaft, auch bei großen Temperaturwechseln die auftretenden Spannungen derart klein zu halten, dass es zu keiner Rissbildung im Gesamtsystem kommt.

Durch die in den Unteransprüchen aufgeführten Maßnahmen sind vorteilhafte Weiterbildungen und Verbesserungen des im Hauptanspruch angegebenen Verbundwerkstoffes möglich.

In vorteilhafter Weise ist die Verteilung der Öffnungen in dem einen Material zumindest annähernd gleichmäßig, so dass der Verbundwerkstoff derart eine gleichmäßige Struktur aufweist, so dass es zu keinen Rissbildungen durch erhöhte Konzentration des einen Materials in gewissen Bereichen des Verbundwerkstoffes kommt.

In besonders bevorzugter Ausführung besteht das eine Material aus Aluminiumoxid, Aluminium, Polycarbonat, Silicatglas oder Zeolithen. Damit werden verschiedenartige Materialien bereitgestellt, die in der Technik weite Verbreitung finden und die oft Probleme hinsichtlich eines Verbundes mit einem anderen Materials mit unterschiedlichem WAK aufweisen. Es kann somit in einfachster Weise eine breite Klasse von neuen Verbundwerkstoffen, basierend auf diesen Materialien, kostengünstig und einfach zur Verfügung gestellt werden.

In besonders bevorzugter Ausführung ist das zweite Material des Verbundwerkstoffes ausgewählt aus der Gruppe, bestehend aus den Münzmetallen, den Eisenmetallen, den Platinmetallen, dotierten oder undotierten metallischen Mischoxiden. Damit ist es möglich, einen weiten Anwendungsbereich von Verbundwerkstoffen unterschiedlichster Zusammensetzung für eine Vielzahl von technischen Anwendungen bereitzustellen. Insbesondere ist es hierbei auch möglich, die extrem großen Wärmeausdehnungskoeffizientenunterschiede, beispielsweise zwischen Metallen und Aluminiumoxid, oder Gläsern und anderen keramischen Materialien in einfacher Weise zu überbrücken.

In einer besonders bevorzugten Ausführung bestehen die dotierten oder undotierten metallischen Mischoxide aus den Verbindungen der Gruppe, bestehend aus den Spinellen, Perowskiten, Elpasolithen, Kryolithen oder Oxiden der dritten bis fünften Nebengruppe, beispielsweise ZrO₂, TiO₂, Ta₂O₅, oder auch Oxiden der dritten Hauptgruppe wie Ga₂O₃, In₂O₃. Hiermit ist insbesondere in einfacher Weise ein Einsatz von Verbundwerkstoffen, beispielsweise in der Sensortechnik möglich, so dass eine Miniaturisierung von Sensoren ohne aufwendige Anpassung der Wärmekoeffizienten der verschiedenen Materialien untereinander, ermöglicht ist.

In einer weiteren bevorzugten Ausführung ist das Mischoxid ein mit Yttrium stabilisiertes Zirkoniumdioxid (YSZ), bzw. Zirkoniumdioxid, welches mit anderen Elementen, beispielsweise Calcium ebenfalls in seiner kubischen Phase stabilisiert ist. Dadurch ist es in vorteilhafter Weise möglich, dass, beispielsweise zur Herstellung von Lambdasonden, neuartige und kostengünstige Verbundmaterialien zur Verfügung gestellt werden, die es erlauben, beispielsweise Aluminiumdioxid mit einem WAK-Wert von 7,5 ppm/K mit YSZ, welches einen WAK-Wert von 11 ppm/K aufweist, in einfachster Weise zu kombinieren, ohne dass Zwischenschichten nötig sind.

Es ist ebenso möglich, statt mit YSZ, die Nanoröhrchen mit TiO₂ oder Ga₂O₃ zu füllen. Zur Sensorherstellung können dann entweder direkt Elektroden auf das gefüllte Substrat aufgedruckt werden, oder aber nach dem Aufdrucken der Elektroden das Substrat mit einer weiteren keramischen Trägerfolie stabilisiert werden.

In einer bevorzugten Ausführung ist die Form der Nanoröhrchen konisch oder/und patronenförmig, so dass beispielsweise nach einem Sinterungsvorgang des aufgefüllten Verbundwerkstoffes die gefüllten Röhrchen, bestehend beispielsweise aus einem Metall, selbst bei einem eventuellen Schrumpfen der Matrix nicht aus dem Material herausfallen können.

Ein vorteilhaftes Verfahren zur Herstellung eines Verbundmaterials besteht darin, daß je nach Art des isolierenden Materials die Löcher durch Beschuß mit einem Teilchenstrom eingebracht werden können. Dies ist beispielsweise bei dünnen Schichten aus Polycarbonat oder sonstigen organischen und metallorganischen polymeren Materialien leicht möglich.

Eine vorteilhafte und einfache Möglichkeit zur Vergrößerung dieser entstandenen Nanoröhrchen entsteht im anschließenden Ätzen des isolierenden Materials entlang dieser Teilchenbahnen.

In ganz bevorzugter Ausführung wird γ-Aluminiumoxid als Material verwendet, welches durch anodische Oxidation von dünnen Aluminiumschichten, beispielsweise in einem Bad aus konzentrierter H₃PO₄ oder Oxalsäure hergestellt wird. Dabei entstehen in besonders vorteilhafter Weise während des Oxidationsprozesses gleichzeitig die Nanoröhrchen in dem Material. Zweckmäßigerweise kann die Form der durchgehenden Löcher sehr einfach durch die Änderung der Abscheidespannung während des anodischen Oxidationsprozesses variiert werden, so daß je nach Anwendung die Form der Löcher von konisch bis patronenförmig über kreiselförmig variiert werden kann.

Vorteilhafterweise erfolgt die Auffüllung der Nanoröhrchen über einen Sol-Gel-Prozeß, bei dem in einer bevorzugten Ausführung Y- und Zr-Alkoxide in einem Sol-Gel-Prozeß eingesetzt werden. Es können jedoch auch andere Alkoxide verwendet werden, so daß beispielsweise ein Material mit diesen Nanoröhrchen, mit verschiedenartigen Vorgängerverbindungen gefüllt werden kann, die anschließend bei einer Temperatur zwischen 800° und 1400° C gesintert und damit in die Endverbindungen umgesetzt werden. Durch das Sintern schrumpft das Gel in den Nanoröhrchen weniger als das Al₂O₃, welches eine nahezu 30%ige Volumenreduktion erfährt.

Die so entstehenden Nanozylinder der Endverbindungen weisen eine geringere Volumenschrumpfung auf, so daß diese nachher fest in dem γ-Al₂O₃-Substrat verankert sind. Je nach Verbindung bilden sich an der Grenzfläche zu Al₃O₃ auch Mischphasen aus, d.h. es entstehen gemische Metalloxidaluminate, beispielsweise Titanaluminat oder Zirkoniumaluminat.

Es ist ebenso möglich, den Sol-Gel Auffüllprozeß erst nach dem Sintern des Al₂O₃-Substrates durchzuführen, so daß beim Sintern zur Umsetzung des Gels in das Endprodukt keine Aluminatphasen mehr auftreten.

### Zeichnung

Ausführungsbeispiele der Erfindung sind in der Zeichnung dargestellt und in der nachfolgenden Beschreibung näher erläutert. Es zeigen Figur 1 einen erfindungsgemäßen Verbundwerkstoff, Figur 2 ein zweites Ausführungsbeispiel und Figur 3 ein weiteres Ausführungsbeispiel des erfindungsgemäßen Verbundwerkstoffs.

### Beschreibung der Ausführungsbeispiele

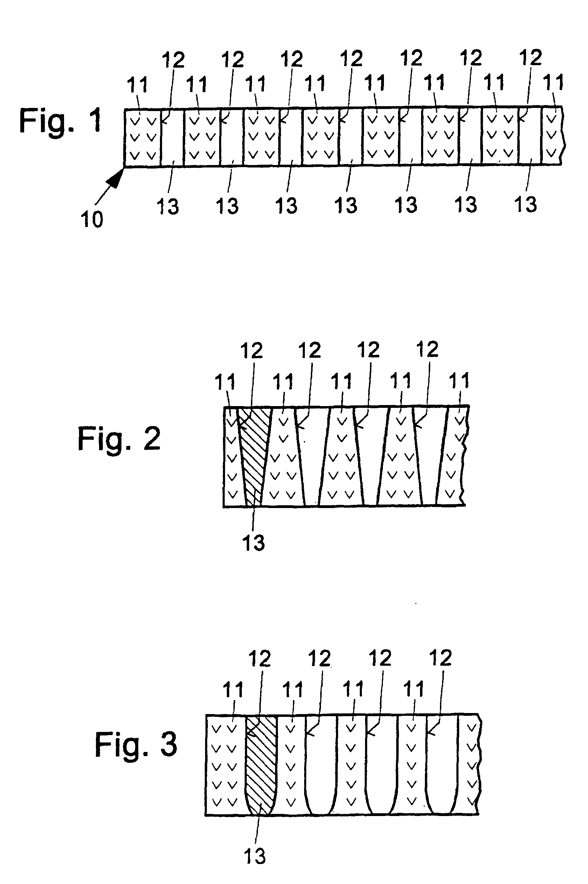

Figur 1 zeigt eine Schicht 10 als eine Platte aus γ-Aluminiumoxid, welches durch anodische Oxidation einer Aluminiumfolie mit einer Dicke von 200 Nanometern und nachfolgendem Sintern bei 1200° C erhalten wurde. Dabei wird die Aluminiumfolie anodisch in einem Bad aus konzentrierter Phosphorsäure oder konzentrierter Oxalsäure oxidiert, wobei gleichzeitig die kleinen, durchgehenden Nanoröhrchen entstehen. Die so erhaltene nanoporöse γ-Aluminiumoxidschicht wird aus dem Bad genommen, mit Wasser abgespült und getrocknet. Anschließend wird diese γ-Aluminiumoxidplatte in ein Bad aus Y- und Zr-Alkoxiden gehängt, beispielsweise können dazu Zirkoniumisopropylat und Yttriumisopropylat verwendet werden, so daß die Aluminiumoxidplatte mit den Nanoröhrchen in die Alkoxidlösung eintaucht. Nach Zugabe der stöchiometrischen Menge an wasser, hydrolysieren die Y- und Zr-Alkoxide und fallen dabei als entsprechende Oxide aus und füllen derart die kleinen Nanoröhrchen des Aluminiumoxides aus. Nach dem Herausnehmen der Nanoröhrchenfolie aus der Alkoxidlösung bilden die ausgefällten Y/Zr-Partikel ein poröses Gelgerüst. Da das γ-Aluminiumoxid beim gemeinsamen Sintern bei etwa 1300° C ebenso wie YSZ eine starke Schwindung erfährt, liegen nach dem Sintern durchgehende YSZ-Kanäle im Aluminiumoxid vor. Diese Kanäle zeigen eine durchgehenende Sauerstoffionenleitfähigkeit. Der gesamte Ausdehnungskoeffizient und die Sinterschwindung liegen in der Nähe der Werte von reinen γ-Aluminiumoxid. Die absoluten Spannungen des Verbundwerkstoffes sind minimal, da die Nanotubedurchmesser nur zwischen 20 und 300 Nanometern liegen. Aus dem mit YSZ gefüllten Nanotubes können in Verbindung mit reinem γ-Aluminiumoxidfolien, die zum Beispiel mit einem Heizer bedruckt werden können, auf einfache und kostengünstige Weise nunmehr Abgassensoren, beispielsweise λ-Sonden, hergestellt werden.

Figur 2 zeigt eine Variation der Form der Nanoröhrchen 12, die in diesem Falle konisch sind. Figur 3 zeigt eine Form der Nanoröhrchen 12, die hier eine patronenförmige Ausbildung erfahren haben. Dies wird durch geeignete Variationen der Abscheidungsspannung während des anodischen Oxidationsprozesses der Aluminiumfolie erzielt. Ebenso kann die Porendichte der durchgehenden Nanoröhrchen 12 durch geeignete Variation der Abscheidungsspannung den jeweils benötigten Nanoröhrchendichten in der Verwendung angepaßt werden. Der maximal mögliche Wert der Porendichte der Nanoröhrchen 12 beträgt 10¹¹ Poren pro Quadratzentimeter. Desweiteren kann der Durchmesser der Nanoröhrchen 12 ebenfalls durch geeignete Variation der Abscheidungsspannung während der anodischen Oxidation der Aluminiumfolie dem späteren Verwendungsprozeß angepaßt werden. Es ist möglich, den Durchmesser der Nanoröhrchen 12 bis auf 5 Nanometerdurchmesser einzustellen. Der maximale Durchmesser der Nanoröhrchen 12 beträgt in etwa 300 Nanometer.

Selbstverständlich stellen die beschriebenen Ausführungsbeispiele keine Einschränkung des Verbundwerkstoffes und des Verfahrens zur Herstellung dieses Verbundwerkstoffes dar, sondern es lassen sich damit Verbundwerkstoffe mit beliebigen anderen Materialkombinationen herstellen, wenn in mindestens einem der Materialien die Nanoröhrchen herstellbar sind.

## Patentansprüche

1. Plattenförmiger Verbundwerkstoff mit mindestens zwei Materialien mit unterschiedlichen Wärmeausdehnungskoeffizienten, wobei ein erstes der Materialien eine Vielzahl von Öffnungen mit einem Durchmesser kleiner als 300 nm aufweist, die die Enden von den Verbundwerkstoff durchdringenden Röhren sind, in welchen sich das zweite Material befindet.

2. Verbundwerkstoff nach Anspruch 1, **dadurch gekennzeichnet, dass** die Verteilung der Öffnungen in dem ersten Material zumindest annähernd gleichmäßig ist.

3. Verbundwerkstoff nach Anspruch 1, **dadurch gekennzeichnet, dass** das erste Material ausgewählt ist aus der Gruppe Aluminiumoxid, Aluminium, Polycarbonat, Silikatglas oder Zeolith.

4. Verbundwerkstoff nach Anspruch 1, **dadurch gekennzeichnet, dass** das zweite Material ausgewählt ist aus der Gruppe der Münzmetalle, der Eisenmetalle, der Platinmetalle oder der dotierten oder undotierten metallischen Mischoxide.

5. Verbundwerkstoff nach Anspruch 4, **dadurch gekennzeichnet, dass** die dotierten oder undotierten metallischen Mischoxide, ausgewählt sind aus der Gruppe der Spinelle, Perowskite, Elpasolithe, Kryolithe oder der Oxide der 2. bis 5. Nebengruppe.

6. Verbundwerkstoff nach Anspruch 5, **dadurch gekennzeichnet, dass** das Mischoxid mit Yttrium stabilisiertes Zirkoniumdioxid (YSZ) ist.

7. Verbundwerkstoff nach Anspruch 1, **dadurch gekennzeichnet, dass** die Form der Röhren konisch und/oder patronenförmig ist.

8. Verfahren zur Herstellung eines Verbundwerkstoffes nach mindestens einem der Ansprüche 1 bis 7, wobei in dem ersten Material eine Vielzahl von den Verbundwerkstoff durchdringenden Röhren erzeugt wird, die anschließend zumindest teilweise mit dem zweiten Material aufgefüllt werden, und wobei die Form der Röhren und/oder die Größe der Öffnungen der Enden der Röhren durch eine Änderung der Abscheidespannung bei einem anodischen Oxidationsprozess variiert wird.

9. Verfahren nach Anspruch 8, **dadurch gekennzeichnet, dass** als erstes Material Aluminiumoxid verwendet und das Aluminiumoxid durch anodische Oxidation von Aluminium hergestellt wird, wobei die Öffnungen während der anodischen Oxidation von Aluminium entstehen.

10. Verfahren nach Anspruch 8, **dadurch gekennzeichnet, dass** das Auffüllen der Röhren über einen Sol-Gel-Prozess erfolgt.

11. Verfahren nach Anspruch 10, **dadurch gekennzeichnet, dass** Y- und Zr-Alkoxide in dem Sol-Gel-Prozess eingesetzt werden.

12. Verfahren nach einem der Ansprüche 8 bis 11, **dadurch gekennzeichnet, dass** die Füllhöhe der Röhren mit einem zweiten Material durch die Verweildauer des ersten Materials in einem Bad aus einer Lösung von Vorläuferverbindungen des zweiten Materials bestimmt wird.

13. Verfahren nach Anspruch 12, **dadurch gekennzeichnet, dass** das in den Röhren zumindest teilweise aufgefüllte erste Material aus dem Bad genommen und bei einer Temperatur zwischen 800°C und 1400°C gesintert wird.

14. Verfahren nach Anspruch 13, **dadurch gekennzeichnet, dass** sich die Vorläuferverbindung für das zweite Material bei der gewählten Sintertemperatur in das zweite Material umwandelt.

15. Verfahren nach Anspruch 8, **dadurch gekennzeichnet, dass** die Röhren durch Beschuss mit einem Teilchenstrom und anschließendem Ätzen des Materials entlang der Teilchenbahn hergestellt werden.

## Claims

1. Composite material in plate form, having at least two materials with different coefficients of thermal expansion, a first material having a multiplicity of openings with a diameter of less than 300 nm, which are the ends of tubes which penetrate through the composite material and in which the second material is situated.

2. Composite material according to Claim 1, **characterized in that** the distribution of the openings in the first material is at least approximately uniform.

3. Composite material according to Claim 1, **characterized in that** the first material is selected from the group consisting of aluminium oxide, aluminium, polycarbonate, silicate glass or zeolite.

4. Composite material according to Claim 1, **characterized in that** the second material is selected from the group consisting of the coinage metals, the ferrous metals, the platinum metals or the doped or undoped metallic mixed oxides.

5. Composite material according to Claim 4, **characterized in that** the doped or undoped metallic mixed oxides are selected from the group consisting of the spinels, perovskites, elpasolites, cryolites or the oxides from the second to fifth sub-group.

6. Composite material according to Claim 5, **characterized in that** the mixed oxide is yttriumstabilized zirconia (YSZ).

7. Composite material according to Claim 1, **characterized in that** the tubes are conical and/or cartridge-shaped.

8. Process for producing a composite material according to at least one of Claims 1 to 7, in which a multiplicity of tubes which penetrate through the composite material are produced in the first material, and these tubes are then at least partially filled with the second material, and in which the shape of the tubes and/or the size of the openings at the ends of the tubes is varied by changing the deposition voltage during an anodic oxidation process.

9. Process according to Claim 8, **characterized in that** aluminium oxide is used as the first material and the aluminium oxide is produced by anodic oxidation of aluminium, the openings being formed during the anodic oxidation of aluminium.

10. Process according to Claim 8, **characterized in that** the tubes are filled using a sol-gel process.

11. Process according to Claim 10, **characterized in that** Y- and Zr-alcoxides are used in the sol-gel process.

12. Process according to one of Claims 8 to 11, **characterized in that** the level to which the tubes are filled with a second material is determined by the residence time of the first material in a bath comprising a solution of precursor compounds of the second material.

13. Process according to Claim 12, **characterized in that** the first material, which has been at least partially filled in the tubes, is taken out of the bath and is sintered at a temperature between 800°C and 1400°C.

14. Process according to Claim 13, **characterized in that** the precursor compound for the second material is converted into the second material at the selected sintering temperature.

15. Process according to Claim 8, **characterized in that** the tubes are produced by bombardment with a stream of particles followed by etching of the material along the path of the particles.

## Revendications

1. Matériau composite en forme de plaque avec au moins deux matériaux présentant des coefficients de dilatation thermique différents, dans lequel le premier des matériaux présente un grand nombre d'ouvertures ayant un diamètre inférieur à 300 nm, qui sont les extrémités de tubes traversant de part en part le matériau composite, dans lesquels se trouve le second matériau.

2. Matériau composite selon la revendication 1,
**caractérisé en ce que**
la répartition des ouvertures dans le premier matériau est au moins approximativement régulière.

3. Matériau composite selon la revendication 1,
**caractérisé en ce que**
le premier matériau est choisi dans le groupe constitué par l'oxyde d'aluminium, l'aluminium, le polycarbonate, le verre silicaté ou la zéolithe.

4. Matériau composite selon la revendication 1,
**caractérisé en ce que**
le second matériau est choisi dans le groupe des métaux de Muntz, des métaux du type du fer, des métaux du type du platine ou des oxydes métalliques mixtes dopés ou non dopés.

5. Matériau composite selon la revendication 4,
**caractérisé en ce que**
les oxydes métalliques mixtes dopés ou non dopés sont choisis dans le groupe des spinelles, des perowskites, des elpasolites, des cryolithes ou des oxydes des deuxième à cinquième groupe secondaire de la classification périodique des éléments.

6. Matériau composite selon la revendication 5,
**caractérisé en ce que**
l'oxyde mixte est du dioxyde de zirconium stabilisé avec de l'yttrium (YSZ).

7. Matériau composite selon la revendication 1,
**caractérisé en ce que**
la forme des tubes est en cône et/ou en cartouche.

8. Procédé de fabrication d'un matériau composite selon au moins une des revendications 1 à 7, dans lequel dans le premier matériau on produit un grand nombre de tubes pénétrant de part en part le matériau composite, qui ensuite sont au moins en partie remplis avec le second matériau, et où l'on fait varier la forme des tubes et/ou la taille des ouvertures des extrémités des tubes par une modification de la tension de dépôt dans un procédé d'oxydation anodique.

9. Procédé selon la revendication 8,
**caractérisé en ce que**
comme premier matériau on utilise l'oxyde d'aluminium et **en ce qu'**on produit l'oxyde d'aluminium par oxydation anodique de l'aluminium, les ouvertures apparaissant au cours de l'oxydation anodique de l'aluminium.

10. Procédé selon la revendication 8,
**caractérisé en ce que**
le remplissage des tubes s'effectue par un procédé sol-gel.

11. Procédé selon la revendication 10,
**caractérisé en ce qu'**
on utilise des alcoxydes d'Y et de Zr dans le procédé sol-gel.

12. Procédé selon l'une des revendications 8 à 11,
**caractérisé en ce que**
la hauteur de remplissage des tubes avec un second matériau est déterminée par le temps de séjour du premier matériau dans un bain constitué d'une solution des composés précurseurs du second matériau.

13. Procédé selon la revendication 12,
**caractérisé en ce qu'**
on retire du bain le premier matériau au moins en partie versé dans les tubes et on le fritte à une température comprise entre 600°C et 1400°C.

14. Procédé selon la revendication 13,
**caractérisé en ce que**
le composé précurseur du second matériau se transforme en le second matériau à la température de frittage choisie.

15. Procédé selon la revendication 8,
**caractérisé en ce que**
les tubes sont produits par bombardement avec un courant partiel puis gravure du matériau le long du trajet des particules.
